# EUROPEAN PATENT SPECIFICATION

(11) **EP 3 152 342 B1**
(45) Date of publication and mention of the grant of the patent: **27.03.2019**
(21) Application number: 15733008.5
(22) Date of filing: 02.06.2015
(51) Int. Cl.: C23C 4/10, C23C 28/00, C23C 16/27, C23C 4/18, C23C 4/067, C23C 28/04

(54) **FLUID TIGHT LOW FRICTION COATING SYSTEMS FOR DYNAMICALLY ENGAGING LOAD BEARING SURFACES**
FLUIDDICHTE REIBUNGSARME BESCHICHTUNGSSYSTEME ZUR DYNAMISCHEN KOPPLUNG LASTENTRAGENDER OBERFLÄCHEN
SYSTÈMES DE REVÊTEMENT À FAIBLE FROTTEMENT ÉTANCHES AUX FLUIDES POUR METTRE DYNAMIQUEMENT EN CONTACT DES SURFACES DE SUPPORT DE CHARGE

(30) Priority: 04.06.2014 US 201462007724 P; 01.06.2015 US 201514727169
(43) Date of publication of application: 12.04.2017
(73) Proprietor: Praxair S.T. Technology, Inc., North Haven, CT 06473 (US)
(72) Inventor: KLEYMAN, Ardy, S., Carmel, IN 46032 (US); KNAPP, James, K., Pittsboro, IN 46167 (US); FEUERSTEIN, Albert, Carmel, IN 46032 (US)
(74) Representative: BRP Renaud & Partner mbB Rechtsanwälte Patentanwälte Steuerberater
(86) International application number: PCT/US2015/033732
(87) International publication number: WO 2015/187658

(56) References cited:
- WO-A1-02/47187
- WO-A1-2013/006062
- WO-A1-2013/129939
- WO-A2-2007/109784
- JP-A- H0 383 365
- US-A1- 2007 163 655
- US-A1- 2007 261 767

## Description

### Field of the Invention

The present invention generally relates to low friction, fluid impermeable novel protective coatings for a variety of applications. Particularly, the coatings offer low friction and enhanced fluid impermeability for engaging surfaces of gate and seat components.

### Background of the Invention

Gate valves are typically used when a straight-line flow of fluid and minimum flow restriction are required. Gate valves are an integral part of wellhead assemblies and piping systems utilized in various supply and pump lines, including oil and gas exploration and production where pressures may range from 34.5 to 206.9 MPa (5,000 to 30,000 psi) or greater. Gate valves consist of a valve body located axially in piping through which fluid flows. Within the valve body is a gate, which is typically a solid metallic component with an aperture extending through the component. In operation, the gate typically slides between two seats, which are circular annulus components having an inside diameter approximately equal to the diameter of the aperture in the gate. The seats are coaxially aligned with and directly or indirectly attached to the ends of the pipe or tubing and in a fixed position thereto, within which the valve is located. When the aperture in the gate is aligned with the holes in the seats, the gate valve is fully open, and the fluid flows freely through the valve. The term "fluid" as used herein and throughout the specification is intended to refer to a liquid, slurry, gas or vapor. When the aperture in the gate is partially or completely misaligned with seats, the gate valve is partially or fully closed, and the fluid flow is impeded or interrupted. When the valve is partially or fully closed, fluid pressure on the upstream side of the valve also presses the gate against the seat on the downstream side.

An actuator is typically utilized to enable sliding of the gate between the seats. The actuation can be manual, hydraulic or pneumatic. The actuation must be able to generate a sufficient amount of force to overcome static and dynamic frictional forces between the seats and the gate. The gate and seat components have a tendency to stick, adhere or cold weld to each other, thereby resulting in high frictional forces. Additionally, the frictional forces can become even larger at higher fluid operating pressures for oil and gas supply and pump lines.

Wear and corrosion is also a problem for oil and gas applications. As a result, the gate valve must be made of corrosion resistant materials, particularly the seats and gate where corrosion of the surfaces exacerbates wear and frictional problems.

As a result of the tendency for such gate valves to be exposed to harsh conditions which can degrade its structural integrity, various protective coatings have been employed. For example, lubricative coatings have been utilized on the sealing faces of the gates and/or seats. Polymeric materials such as thermoplastics have been applied onto at least one of the surfaces to reduce friction and impart lubricity. However, such coatings have proven unacceptable, as frictional problems may develop over time and eventually increase to an enhanced level that can result in sticking or uneven movement o the valve gate during operation. The loss of lubrication can lead to unacceptable valve torques which may lead to local deformation and/or galling of mating surfaces.

Wear resistant coatings such as WCCrCo are another type of protective coating routinely utilized. While the wear resistant coatings have proven successful at lower operating pressure regimes of 103.4 MPa (15,000 psi) or less, they are typically inadequate as the oil supply and pump lines approach higher pressures. In particular, gas leakage through the coatings can occur. Additionally, the coatings lose their lubricity and exhibit galling, thereby rendering such coatings inadequate.

Failure to utilize a coating having adequate fluid impermeability, in combination with adequate wear resistance and lubrication of the gate and seats components can, among other problems, lead to unacceptable galling and potential localized deformation, thereby causing leakage of fluid through the coating and eventually through the valve.

In view of the drawbacks of conventional coatings, there is an unmet need for an improved protective coating system that offers superior performance over conventional coating materials for gate and seat components, including improved wear resistance, lubricity and sealing properties over a wide range of operating pressures and temperatures.

WO2013/129939 relates to the deposition of both opposing sealing surfaces for gate and seats. However, DLC is used preferably as the top coating on top of e.g. WC also on the second sealing surface.

### Summary of the Invention

The present invention is a protective coating system as it is defined in claim 1. Preferred embodiments of such protective coating system are defined in the dependent claims .

Other aspects, features and embodiments of the disclosure will be more fully apparent from the ensuing description and appended claims.

### Brief Description of the Drawings

The objectives and advantages of the invention will be better understood from the following detailed description of the preferred embodiments thereof in connection with the accompanying figures wherein like numbers denote same features throughout and wherein:

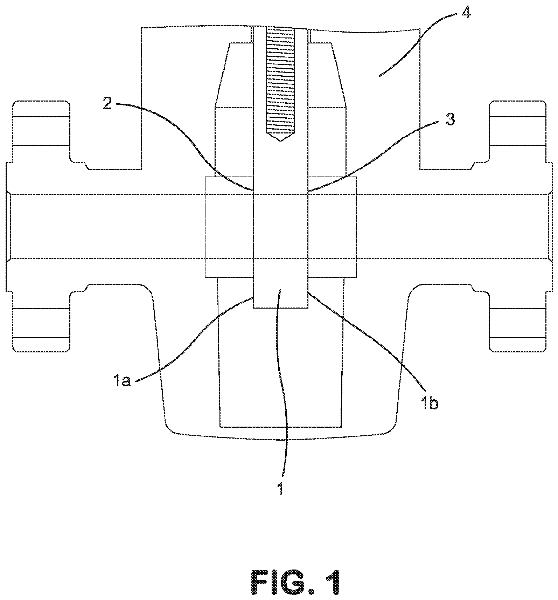

Figure 1 shows a cross-sectional view of a gate valve with the gate disengaged from the seat to allow fluid flow through the passageway;

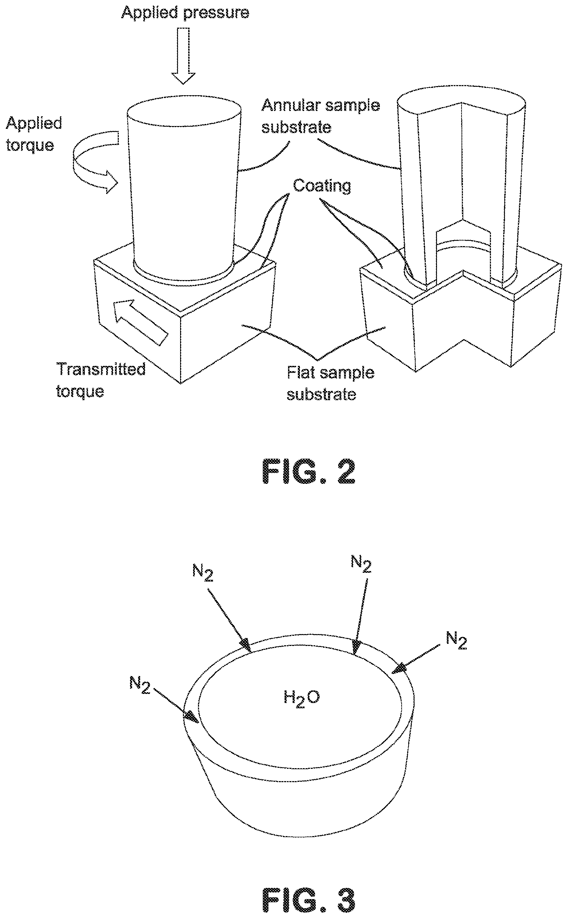

Figure 2 shows a test set-up of a twist compression test employed to replicate frictional behavior incurred by opening and closing of gate valves;
Figure 3 shows a test set-up employed to replicate high pressure leakage which may be encountered by gate valves utilized in oil and gas applications;

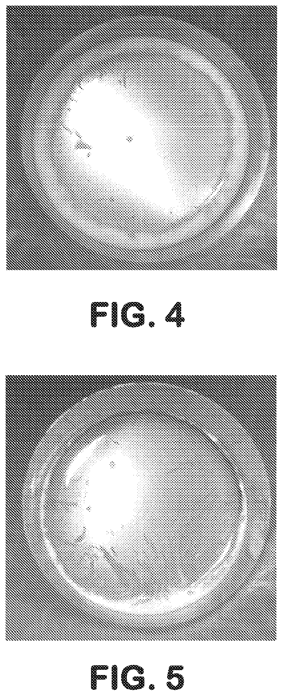

Figure 4 shows an unsealed Super D-gun® coating (deposited from a powder comprising tungsten carbide-cobalt-chromium material and 5 to 35 weight percent of a cobalt alloy) that exhibited leakage through the coating at less than 6.9 MPa (1,000 psi) pressure during testing performed as described in Comparative Example 1;
Figure 5 shows an unsealed Super D-gun® coating (deposited from a powder comprising tungsten carbide-cobalt-chromium material and 5 to 35 weight percent of a cobalt alloy) and with a diamond-like carbon layer that exhibited leakage through the coating at an applied pressure of less than 6.9 MPa (1,000 psi) during testing performed as described in Comparative Example 2;

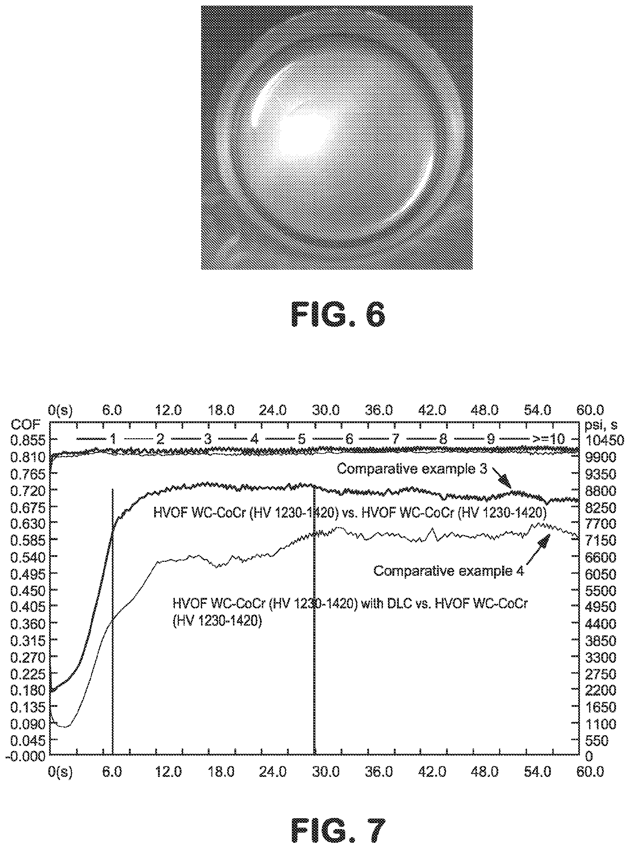

Figure 6 shows a protective coating composition of the present invention (Super D-gun® coating deposited from the powder comprising tungsten carbide-cobalt-chromium material and 5 to 35 weight percent of a cobalt alloy with a diamond-like carbon layer which was then sealed after application of the diamond-like carbon layer) that exhibited an absence of leakage through the coating at an applied pressure of 69.0 MPa (10,000 psi) during testing performed as described in Example 1;
Figure 7 shows a graphical relationship of the effects of coefficient of friction upon incorporating a diamond-like carbon material into a thermal spray coating whereby the diamond-like carbon material was applied over a WC-CoCr HVOF coating and tested against a WC-CoCr HVOF coating at 69.0 kPa (10 ksi) contact pressure with no grease;

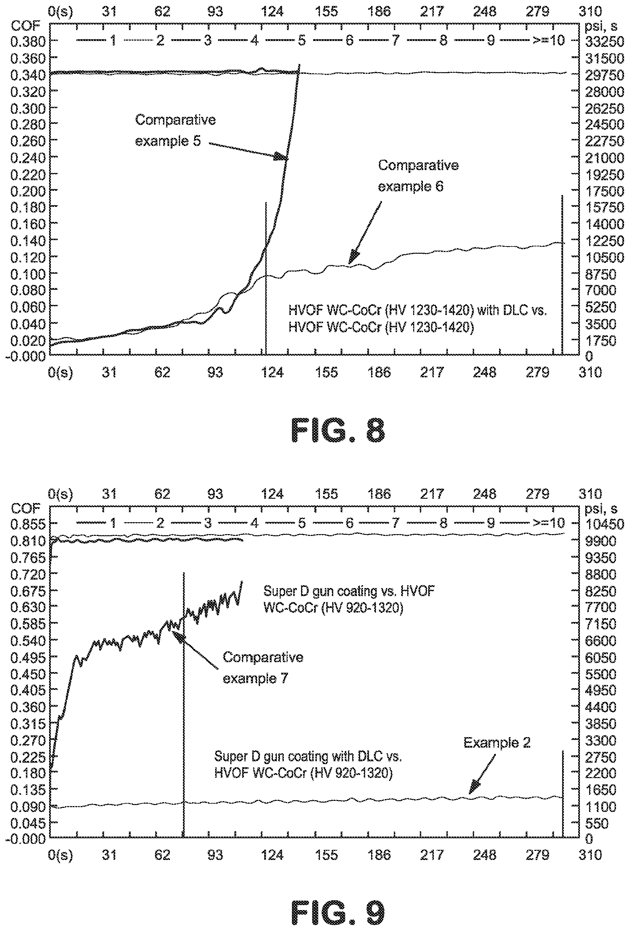

Figure 8 shows a graphical relationship of the effects of coefficient of friction upon incorporating a diamond-like carbon material into a thermal spray coating, whereby the diamond-like carbon material was applied over a WC-CoCr HVOF coating and tested against a WC-CoCr HVOF coating at 206.9 kPa (30 ksi) contact pressure with grease;
Figure 9 shows a graphical relationship of the effects of coefficient of friction when utilizing a coating of the present invention, whereby a diamond-like carbon material was applied over a Super D-gun® coating deposited from a powder comprising tungsten carbide-cobalt-chromium material and 5 to 35 weight percent of a cobalt alloy and tested against a WC-CoCr HVOF coating at 6.9 kPa (10 ksi) contact pressure with no grease; and

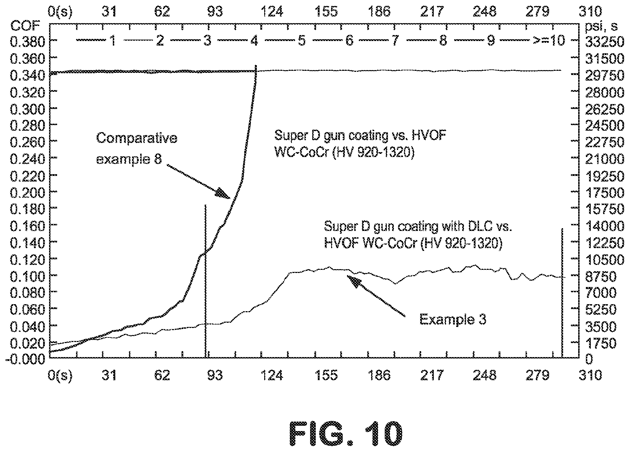

Figure 10 shows a graphical relationship of the effects of coefficient of friction when utilizing a coating of the present invention, whereby a diamond-like carbon material was applied over a Super D-gun® coating (comprising tungsten carbide-cobalt-chromium material and 5 to 35 weight percent of a cobalt alloy) and tested against a WC-CoCr HVOF coating at 206.9 kPa (30 ksi) contact pressure with grease.

### Detailed Description of the Invention

The disclosure is set out herein in various embodiments, and with reference to various features and aspects of the invention. The disclosure contemplates such features, aspects and embodiments in various permutations and combinations, as being within the scope of the disclosure. The disclosure may therefore be specified as comprising, consisting or consisting essentially of, any of such combinations and permutations of these specific features, aspects and embodiments, or a selected one or ones thereof.

Unless indicated otherwise, all compositions herein are in weight percent, not including unavoidable trace contaminants.

The present invention relates to novel protective coatings according to claim 1 which are defined at least in part by their low friction and fluid impermeability for a variety of applications. The coatings are particularly suitable for maintaining structural integrity of load bearing surfaces, such as the gate and seat surfaces of a gate valve according to claim 6. The coatings offer improved and sustained wear resistance, corrosion protection and the ability to create and maintain lubricity and a substantially impermeable seal through the coating and along one or more load bearing surfaces which, during operation, engage with other sealing surfaces at elevated service pressures, such as for example, 34.5 to 206.9 MPa (5,000 to 30,000 psi) or more. In this regard, the present invention represents a significant improvement over conventional coatings and coating systems for gate and seat components, both of which are susceptible to leakage during service, and therefore not able to maintain a seal. As today's oil and gas applications continue to require higher operating pressures and temperatures, conventional coatings and coatings systems are unable to create and maintain the necessary seal and lubricity on the engaging surfaces of a gate and seat that are subject to ever increasing loads for prolonged periods of time.

A protective coating system is provided having various constituents, including a carbide-based thermal spray composition; a low friction layer of material; and a polymeric sealant. Each of the constituents is chemically and physically compatible with each other, thereby eliminating deleterious degradation reactions which could potentially affect the structural integrity of the protective coating system. It should be understood that the term "layer" as used herein and throughout the specification is intended to refer to one or more layers which can be discrete or continuous.

The carbide-based thermal composition overlies a sealing surface of a substrate. The carbide-based thermal composition is characterized as a hardened layer that provides wear resistance and corrosion resistance. In a preferred embodiment, the carbide-based composition is derived from a powder blend of a tungsten carbide-cobalt chromium material and a metallic cobalt alloy (i.e., carbide-cobalt), whereby the tungsten carbide-cobalt-chromium material has a formulation that comprises tungsten carbide-5% to 20% cobalt and 0% to 12% chromium, and more preferably about 8% to 13% cobalt and 0% or 4% to 10% chromium. Details of the tungsten carbide-cobalt chromium material blended with the metallic cobalt alloy (i.e., carbide-cobalt) are described in U.S. Patent No. 6004372. Other carbide-based compositions are also contemplated by the present invention.

The metallic alloy is preferably a cobalt alloy with a formulation which comprises 27% to 29% chromium, 7% to 9% tungsten, 0.8% to 1.2% carbon and the balance cobalt. More preferably, the cobalt alloy comprises cobalt-28% chromium-8% tungsten-1% carbon. Other metallic alloys are contemplated by the present invention, including, but not limited to, a metallic alloy composition comprising 25% to 31% molybdenum, 14% to 20% chromium, 1% to 5% silicon, less than 0.08% carbon, and the balance cobalt. Still further, another metallic alloy is a cobalt alloy having a formulation of cobalt-28% molybdenum-17% chromium-3% silicon-less than 0.08% carbon. Various carbide-cobalt thermal spray compositions are contemplated, including those selected from the group consisting of WC-CoCr, WC-Co, WC-Ni, and Chromium Carbide-NiCr.

Preferably, the blend comprises 5% to 35% metallic cobalt alloy, and more preferably 10% to 30% metallic cobalt alloy. The tungsten carbide-cobalt-chromium material can be made by various suitable processes, including, by way of example, a cast and crush powder manufacturing technique which is preferred when the chromium content is approximately 0%. Alternatively, a sintering process is preferred when the chromium content is from about 2% to 12%. The metallic cobalt alloy may be produced by any known method, including vacuum melting and inert gas atomization.

The carbide-based thermal composition can be applied onto any type of substrate. Preferably, the composition is the carbide-cobalt blended powder, which is applied onto a sealing surface of a substrate by a suitable thermal spray processes. The thermal spray process may include a detonation gun deposition process, such as a D-gun™ or Super-D gun® processes which are used to produce the coating onto the sealing surface of the substrate. Details for the detonation processes are described in U.S. Patent Nos. 4626477; 4826734; 4902539; 4999255; 5326645; 5652028; 5700423; and 5741556. The carbide-cobalt powder is preferably sized to less than 325 U.S. standard screen mesh (44 micrometers) and the metallic cobalt alloy sized to less than 270 mesh (60 micrometers), but greater than 325 mesh (44 micrometers) by screening. It should be understood that other thermal spray deposition techniques can be utilized with the present invention.

The second constituent of the protective coating system is a low friction coating. The low friction coating is a diamond-like carbon layer (DLC). The DLC is applied onto an outer portion or free surface of the carbide-based thermal coating composition to thereby create a DLC coating region overlying the carbide-based thermal composition. The DLC has a predetermined thickness, which ranges from about 1 to 4 µm, preferably from about 1 to 3 µm, and more preferably from about 2 to 3 µm. Incorporation of the DLC at the predetermined thickness substantially lowers the friction of the underlying carbide-based thermal composition in a manner that imparts lubricity to the exposed regions of the protective coating system without deleteriously impacting wear resistance and corrosion resistance properties of the carbide-based thermal composition. The result is a reduction in friction between the gate and seat components. Representative examples of DLC materials include, but are not limited to, hydrogenated amorphous carbon (designated as "a-C:H") and hydrogenated tetrahedral amorphous carbon (designated as "ta-C:H"). DLC coatings may be deposited by any suitable technique, and advantageously at temperatures not exceeding 204 °C (400 °F) so as to not affect substrate and coating material properties.

The present invention has discovered that a low friction material, DLC, in combination with a carbide-based thermal composition does not adequately create and maintain a fluid-tight (i.e., substantially impermeable) seal of a gate valve (as shown by the representative example in Figure 1) during its service life. The inability to form a fluid-tight seal can be more problematic when service or operating pressures increase beyond 34.5 MPa (5,000 psi) to moderate levels or elevated levels approaching 206.9 MPa (30,000 psi) or greater. Additionally, corrosive fluids and sustained service life (i.e., repeated cycles of opening and closing of gate valve 11) exacerbates the problem. As will be shown in the working examples, coatings which incorporate a DLC cannot form an impermeable fluid-tight seal at moderate or elevated pressures.

In this regard, the protective coating system of the present invention is formulated with a specific type of polymeric or non-polymeric sealant. The sealant is impregnated into the low friction layer and optionally the carbide layer. Preferably, the sealant layer is impregnated into both the low friction layer and the carbide layer. The sealant flows within the pores of the low friction layer and penetrates into the low friction layer and, preferably, the carbide based thermal sprayed layer. The sealant is able to penetrate from the outer free surface of the low friction layer and into the pores, thereby not increasing the overall thickness of the coating system. The end result is a fluid-tight protective coating system that is achieved without compromising lubricity of the low friction layer. The working examples that will be discussed below quantify the improved performance of the protective coating system of the present invention in comparison to conventional coatings and coating systems.

Sealants suitable for the present invention include polymeric (i.e., thermoplastic or thermoset) as well as non-polymeric sealants. Typical organic sealants useful in this invention, include but are not limited to, epoxies (e.g., Bisphenol A, Bisphenol F, Novolac, Aliphatic, and Glycidylamine), silicones, phenolics, polyamide-imides, flouroresins, urethanes and vinyls. Typical inorganic sealants useful in the present invention include, but are not limited to, phosphates, chromates, silicates and chromic acid. Preferably, the sealant is Bisphenol A based epoxy resin,

Selection of a suitable sealant is dependent upon several factors, including chemical and physical compatibility of the sealant with the low friction layer; the specific type of carbide-based thermal spray coating; the gate valve service temperature; and the degree of porosity of the low friction layer.

The sealant is considered the third constituent to be added into the low friction layer and/or underlying carbide-based layer. The sealant is added after formation of each of the underlying carbide-based layer and the low friction layer. The sealant is preferably applied onto the low friction layer by brushing or dipping following by curing at room temperature fora minimum of 8 hours.

The protective coating system of the present invention is suitable for any substrate surface, including, by way of example, and not intending to be limiting, aviation components in which the cylinders or their mating surfaces (bushings or bearings) are at least partially coated. Additionally, the coating systems of the present invention are particularly suitable for metallic load bearing surfaces, including, but not limited to, gate and seat components of the gate valves for the oil and gas industry. Referring to Figure 1, the coating system can be applied to the engaging surfaces 2 and 3 of both seats. Unlike conventional materials, the coating systems of the present invention achieves and prevents fluid leakage through the coating, without adversely impacting lubricity, wear resistance and corrosion resistance during the service life of the gate valve 4. In operation, when moving the gate 1 across the faces 2 and 3 of the seats, the protective coating system provides for a reduced coefficient of friction, reduced wear, and galling prevention while creating and maintaining a fluid-tight seal through the coating when the gate valve 4 is moved down into the closed position with seat faces 2 and 3. As the working examples will show, such properties remain even after numerous cycles.

Preferably, the coating system is applied onto the engaging faces of the seats 2 and 3 and the gate faces 1a and 1b. Specific pairings on the faces 2 and 3 of the seats and the gate faces 1a and 1b can include a Super D-gun® coating that is derived from a powder blend of a tungsten carbide-cobalt chromium material and a metallic cobalt alloy applied to a seat surface in combination with a HVOF (high velocity oxygen fuel) deposited tungsten carbide-cobalt chromium coating applied to a gate surface.

It should be understood that variations are contemplated. According to claim 6, the protective coating system is applied onto either of the faces 2 and 3 for the seats and gate 1 while the other face is coated with only a carbide-based thermal spray composition that is optionally coated with a low friction layer.

As will be shown and discussed below in the Working Examples, several experiments were performed to compare the protective coatings with other conventional materials. The criteria for a successful protective coating system were dependent upon its ability to achieve and create a fluid tight impermeable seal while maintaining a low coefficient of friction.

The experiments simulated high pressure conditions typically encountered by gate valves utilized in oil and gas applications. A twist compression test was used to replicate frictional behavior incurred by opening and closing of gate valves. The friction behavior of different coating systems was investigated using a twist compression test at 69.0 MPa (10,000 psi) contact pressure with no lubrication and at 206.9 MPa (30,000 psi) contact pressure with grease lubrication. The schematic of the test-up is shown in Figure 2. The coating to be tested was applied between the annular sample substrate and the flat sample substrate as shown in Figure 2. The test was performed with an annular cylinder which was driven by a hydraulic motor brought into contact with a flat sample. When the desired pressure had been generated, the annular sample was rotated. Torque transmission between a rotating annular cylinder and a flat sample was measured. Data was collected electronically and the coefficient of friction was calculated from the ratio of transmitted torque to applied pressure.

A second test set-up as shown in Figure 3 was used to replicate high pressure leakage, which may be encountered by gate valves utilized in oil and gas applications. High pressure leak testing was used to investigate the gas leakage through the coating. The test consisted of subjecting a portion of a coated sample to nitrogen at a pressure of 69.0 MPa (10,000 psi) for a minimum of 10 min as shown by the arrows in Figure 3 while another portion of the coated sample was submitted to atmospheric pressure and covered with a thin layer of soapy water. If the coating was permeable to the nitrogen gas, bubbles were observed on the coating surface during the test.

### COMPARATIVE EXAMPLE 1 (leak test for carbide-based thermal spray composition - fig4)

A powder blend of a tungsten carbide-cobalt chromium material and a metallic cobalt alloy was employed to produce a coating using a Super D-gun® coating process. The coating was applied to the test sample having a diameter of approximately 7.1 cm (2.8 inches) and a thickness of approximately 3.8 cm (1.5 inches). No low friction layer was applied, and no sealant was impregnated into the coating system.

A high pressure leak test was conducted. A significant amount of bubbles was observed along the periphery of the test sample as shown in Figure 4 at an applied pressure of less than 6.9 MPa (1,000 psi). The large amount of bubbles was an indication of the inability of the coating to prevent leakage at low pressures. No sealant was impregnated into the coating.

### COMPARATIVE EXAMPLE 2 (leak test for carbide-based thermal spray composition + DLC - fig 5)

A powder blend of a tungsten carbide-cobalt chromium material and a metallic cobalt alloy was employed to produce a coating using a_Super D-gun® coating process. The coating was applied to the test sample having a diameter of approximately 7.1 cm (2.8 inches) in diameter and a thickness of approximately 3.8 cm (1.5 inches). Next, a low friction layer of DLC was applied to the sample by a Plasma activated chemical vapor deposition (Pa CVD) process. No sealant was impregnated into the coating system.

A high pressure leak test was conducted to the resultant coating. A significant amount of bubbles was observed along the periphery of the tested sample as shown in Figure 5 at an applied pressure of less than 6.9 MPa (1,000 The large amount of bubbles was an indication of the inability of the coating with DLC to prevent leakage at low pressures.

### COMPARATIVE EXAMPLE 3 (Friction test for carbide-based thermal spray composition (HVOF) at 69.0 MPa test (10,000psi) -fig 7 red line)

The frictional behavior of a thermal spray coating system was evaluated using the twist compression test at 69.0 MPa (10,000 psi) contact pressure with no lubrication. The coating to be tested was a HVOF WC-CoCr coating, which was applied to both the annular sample substrate and the flat sample substrate. When a pressure of 69.0 MPa (10,000 psi) was generated, the annular sample was rotated. Torque transmission between a rotating annular cylinder and a flat sample was measured, and the coefficient of friction was calculated from the ratio of transmitted torque to applied pressure.

Figure 7 shows the results in a graphical format. The coating system exhibited a stabilized coefficient of friction of about 0.720, which was considered unacceptably high for intended applications.

### COMPARATIVE EXAMPLE 4 (friction test for carbide-baed thermal spray composition (HVOF) + DLC at 69.0 MPa (10,000 psi) -fig 7 orange line)

The frictional behavior of the thermal spray coating system of Comparative Example 3 with the addition of a DLC onto the HVOF coated annular sample was evaluated using the twist compression test at 69.0 MPa (10,000 psi) contact pressure with no lubrication. The DLC was applied onto the surface by Pa CVD. When a pressure of 69.0 MPa (10,000 psi) was generated, the annular sample was rotated. Torque transmission between a rotating annular cylinder and a flat sample was measured, and the coefficient of friction was calculated from the ratio of transmitted torque to applied pressure.

Figure 7 shows the results in a graphical format. The coating system stabilized to a coefficient of friction value of about .585. This was notably lower than that of Comparative Example 3. The results indicated that the DLC served as a low friction layer that reduced the overall coefficient of friction of the coating system. However, the coefficient of friction was still considered inadequate.

### COMPARATIVE EXAMPLE 5 (friction test for carbide-based thermal spray composition (HVOF) at 206.9 MPa (30,000 psi) -fig 8 red line)

The frictional behavior of a thermal spray coating system was evaluated using the twist compression test at about 206.9 MPa (30,000 psi) contact pressure with grease. The coating to be tested was a HVOF WC-CoCr coating, which was applied to both the annular sample substrate and the flat sample substrate. When a pressure of 206.9 MPa (30,000 psi) was generated, the annular sample was rotated. Torque transmission between a rotating annular cylinder and a flat sample was measured, and the coefficient of friction was calculated from the ratio of transmitted torque to applied pressure.

Figure 8 shows the results in a graphical format. The coefficient of friction between the annular substrate and flat sample substrate exponentially increased without stabilizing during the test.

### COMPARATIVE EXAMPLE 6 (friction test for carbide-based thermal spray composition (HVOF) + DLC at 206.9 MPa (30,000 psi) -fig 8 orange line)

The frictional behavior of the thermal spray coating system of Comparative Example 4 with the addition of a DLC onto the HVOF coated annular sample was evaluated using the twist compression test at 206.9 MPa (30,000 psi) contact pressure with grease. The DLC was applied onto the surface by PaCVD. When a pressure of 206.9 MPa (30,000 psi) was generated, the annular sample was rotated. Torque transmission between a rotating annular cylinder and a flat sample was measured, and the coefficient of friction was calculated from the ratio of transmitted torque to applied pressure.

Figure 8 shows the results in a graphical format. The coating system gradually increased to a value of .140. At 206.9 MPa (30,000 psi) grease was used, while at 69.0 MPa (10,000 psi) test was performed at dry conditions. The results indicated that the DLC served as a low friction layer that reduced the overall coefficient of friction of the coating system.

### COMPARATIVE EXAMPLE 7 (friction test for carbide-based detonation gun thermal spray composition (Super D-gun) at 69.0 MPa (10,000 psi) -fig 9 red line)

The frictional behavior of a thermal spray coating system was evaluated using the twist compression test at 69.0 MPa (10,000 psi) contact pressure with no lubrication. The coating to be tested was a Super D-gun® coating derived from a powder blend of a tungsten carbide-cobalt chromium material and a metallic cobalt alloy. The Super D-gun® coating was deposited onto the annular sample substrate. The other coating was a HVOF WC-CoCr coating that was deposited onto the flat sample substrate. When a pressure of 69.0 MPa (10,000 psi) was generated, the annular sample was rotated. Torque transmission between a rotating annular cylinder and a flat sample was measured, and the coefficient of friction was calculated from the ratio of transmitted torque to applied pressure.

Figure 9 shows the results in a graphical format. The coating system gradually increased in coefficient of friction during the course of the test.

### COMPARATIVE EXAMPLE 8 (friction test for carbide-based detonation gun thermal spray composition (Super D-gun) at 206.9 MPa (30,000 psi) -fig 10 red line)

The frictional behavior of a thermal spray coating system was evaluated using the twist compression test at about 206.9 MPa (30,000 psi) contact pressure with grease. The coating to be tested was a Super D-gun® coating derived from the powder blend of a tungsten carbide-cobalt chromium material and a metallic cobalt alloy. The Super D-gun® coating was deposited onto the annular sample substrate. The other coating was a HVOF WC-CoCr coating which was deposited onto the flat sample substrate. When a pressure of 206.9 MPa (30,000 psi) generated, the annular sample was rotated. Torque transmission between a rotating annular cylinder and a flat sample was measured, and the coefficient of friction was calculated from the ratio of transmitted torque to applied pressure.

Figure 10 shows the results in a graphical format. The coating system exponentially increased in its coefficient of friction during the course of the test.

### EXAMPLE 1 (leak test -fig 6)

A powder blend of a tungsten carbide-cobalt chromium material and a metallic cobalt alloy was employed to produce a coating using a Super D-gun® coating process. The coating was applied to the test sample having a diameter of approximately 7.1 cm (2.8 inches) and a thickness of approximately 3.8 cm (1.5 inches). A low friction layer of DLC was applied onto the underlying coating. The DLC was applied by PaCVD.

A high pressure leak test was conducted. No bubbles were observed along the periphery of the tested sample as shown in Figure 6 at an applied pressure of 69.0 MPa (10,000 psi) after 10 minutes of testing. The lack of bubbles at high pressure was an indication of the ability of the coating with DLC and with sealant to prevent leakage.

### EXAMPLE 2 (friction test at 69.0 MPa (10,000 psi) -fig 9 orange line)

The frictional behavior of the inventive thermal spray coating system was evaluated using the twist compression test at 69.0 MPa (10,000 psi) contact pressure with no lubrication. The coating to be tested was a Super D-gun® coating derived from a powder blend of a tungsten carbide-cobalt chromium material and a metallic cobalt alloy. The Super D-gun® coating was deposited onto the annular sample substrate. The other coating was a HVOF WC-CoCr coating which was deposited onto the flat sample substrate. A low friction layer of DLC was applied onto the underlying Super D-gun® coating. The DLC was applied by the Pa CVD process.

When a pressure of 69.0 MPa (10,000 psi) generated, the annular sample was rotated. Torque transmission between a rotating annular cylinder and a flat sample was measured, and the coefficient of friction was calculated from the ratio of transmitted torque to applied pressure.

Figure 9 shows the results in a graphical format. The coating system maintained an acceptably low coefficient of friction of .090 during the entire duration of the test.

### EXAMPLE 3 (friction test at 206.9 MPa (30,000 psi) -fig 10 orange line)

The frictional behavior of an inventive thermal spray coating system was evaluated using the twist compression test at 206.9 MPa (30,000 psi) contact pressure with grease. The coating to be tested was a Super D-gun® coating derived from a powder blend of a tungsten carbide-cobalt chromium material and a metallic cobalt alloy. The Super D-gun® coating was deposited onto the annular sample substrate. The other coating was a HVOF WC-CoCr coating, which was deposited onto the flat sample substrate. A low friction layer of DLC was applied onto the underlying coating Super D-gun® coating. The DLC was applied by a PaCVD process.

When a pressure of 206.9 MPa (30,000 psi) was generated, the annular sample was rotated. Torque transmission between a rotating annular cylinder and a flat sample was measured, and the coefficient of friction was calculated from the ratio of transmitted torque to applied pressure.

Figure 10 shows the results in a graphical format. The coating system maintained an acceptably low coefficient of friction of 100 during the entire duration of the test.

## Claims

1. A protective coating system comprising:
an underlying carbide-based thermal spray compositional layer overlying at least one or more sealing surfaces;
a low friction layer applied onto an outer portion or free surface of said underlying carbide-based thermal spray composition, wherein said low friction layer is a diamond-like carbon material (DLC) having a predetermined thickness;
a polymeric or non-polymeric sealant compatible with said low friction layer and said underlying carbide-based thermal spray composition, said polymeric sealant penetrating into the predetermined thickness of the diamond-like carbon layer and optionally into at least a portion of the underlying carbide-based thermal spray composition;
wherein said coating is **characterized by** fluid-tight impermeability and a reduced coefficient of friction at elevated operating pressures; and
wherein said coating is coated on a sealing surface and a second coating is applied onto a corresponding sealing surface, wherein said second coating is selected from the group consisting of WC-CoCr, WC-Co, WC-Ni, Chromium Carbide-NiCr and cobalt-based metallic alloys.

2. The protective coating system of claim 1, wherein said carbide-based thermal spray coating consists essentially of powder blend of a tungsten carbide-cobalt chromium material and 5 wt% to 35 wt% of a metallic cobalt alloy.

3. The protective coating system of claim 1, wherein said at least one or more sealing surfaces are a gate component or a seat component.

4. The protective coating system of claim 1, wherein said carbide-based thermal spray composition is selected from the group consisting of WC-CoCr, WC-Co, WC-Ni, Chromium Carbide-NiCr and cobalt-based metallic alloys.

5. The protective coating system of claim 1, wherein said DLC has a thickness of 1 to 4 µm.

6. A surface treated apparatus comprising:
a gate valve including a cavity and a flow passage extending along an interior of said body and traversing said cavity;
said valve further defined at least in part by a seat and a gate, said seat affixed to the body at a location defined by an intersection of said cavity and said flow passage;
said gate having an engaging face that slidably engages with a corresponding face of said seat;
wherein said engaging face of gate and seat are coated with the protective coating system of any one of the preceding claims.

## Patentansprüche

1. Schutzbeschichtungssystem, umfassend:
eine zugrundeliegende carbidbasierte, thermische Sprühzusammensetzungsschicht, die über mindestens einer oder mehreren Abdichtungsoberflächen liegt;
eine Schicht mit geringer Reibung, die auf einen Außenabschnitt oder eine freie Oberfläche der zugrundeliegenden carbidbasierten, thermischen Sprühzusammensetzung aufgetragen ist, wobei die Schicht mit geringer Reibung ein diamantartiges Kohlenstoffmaterial (DLC) mit einer vorgegebenen Dicke ist;
ein polymeres oder nichtpolymeres Dichtmittel, das mit der Schicht mit geringer Reibung und der zugrundeliegenden carbidbasierten, thermischen Sprühzusammensetzung kompatibel ist, wobei das polymere Dichtmittel in die vorgegebene Dicke der diamantartigen Kohlenstoffschicht und wahlweise in mindestens einen Abschnitt der zugrundeliegenden carbidbasierten, thermischen Sprühzusammensetzung eindringt;
wobei die Beschichtung durch fluiddichte Undurchlässigkeit und einen verringerten Reibungskoeffizienten bei erhöhten Betriebsdrücken gekennzeichnet ist; und
wobei die Beschichtung auf eine Abdichtungsoberfläche aufgetragen ist und eine zweite Beschichtung auf eine entsprechende Abdichtungsoberfläche aufgetragen ist, wobei die zweite Beschichtung ausgewählt ist aus der Gruppe, bestehend aus WC-CoCr, WC-Co, WC-Ni, Chromcarbid-NiCr und cobaltbasierten, metallischen Legierungen.

2. Schutzbeschichtungssystem nach Anspruch 1, wobei die carbidbasierte, thermische Sprühbeschichtung im Wesentlichen aus einer Pulvermischung aus einem Wolframcarbidcobaltchrommaterial und zu 5 Gew.-% bis 35 Gew.-% aus einer metallischen Cobaltlegierung besteht.

3. Schutzbeschichtungssystem nach Anspruch 1, wobei die mindestens eine oder mehreren Abdichtungsoberflächen eine Schieberkomponente oder eine Auflagerkomponente sind.

4. Schutzbeschichtungssystem nach Anspruch 1, wobei die carbidbasierte, thermische Sprühzusammensetzung ausgewählt ist aus der Gruppe, bestehend aus WC-CoCr, WC-Co, WC-Ni, Chromcarbid-NiCr und cobaltbasierten, metallischen Legierungen.

5. Schutzbeschichtungssystem nach Anspruch 1, wobei das DLC eine Dicke von 1 bis 4 µm aufweist.

6. Oberflächenbehandelte Vorrichtung, umfassend:
ein Schieberventil, das einen Hohlraum und einen Strömungskanal einschließt, der entlang eines Innenraums des Körpers verläuft und den Hohlraum durchquert;
wobei das Ventil ferner mindestens teilweise durch ein Auflager und einen Schieber definiert ist, wobei das Auflager an einer Stelle, die durch einen Schnittpunkt des Hohlraums und des Strömungskanals definiert ist, an dem Körper befestigt ist;
wobei der Schieber eine Eingriffsfläche aufweist, die gleitfähig mit einer entsprechenden Fläche des Auflagers in Eingriff ist;
wobei die Eingriffsfläche von Schieber und Auflager mit dem Schutzbeschichtungssystem nach einem der vorstehenden Ansprüche beschichtet ist.

## Revendications

1. Système de revêtement protecteur comprenant :
une couche compositionnelle sous-jacente de pulvérisation thermique à base de carbure qui se trouve au-dessus d'au moins une ou plusieurs surfaces d'étanchéité ;
une couche à faible frottement appliquée sur une partie externe ou une surface libre de ladite composition sous-jacente de pulvérisation thermique à base de carbure, dans lequel ladite couche à faible frottement est un matériau carboné de type diamant (DLC) ayant une épaisseur prédéterminée ;
un mastic polymère ou non polymère compatible avec ladite couche à faible frottement et ladite composition sous-jacente de pulvérisation thermique à base de carbure, ledit mastic polymère pénétrant dans l'épaisseur prédéterminée de la couche de carbone de type diamant et éventuellement dans au moins une partie de la composition sous-jacente de pulvérisation thermique à base de carbure ;
dans lequel ledit revêtement est **caractérisé par** une imperméabilité étanche aux fluides et un coefficient de frottement réduit à des pressions élevées d'exploitation ; et
dans lequel ledit revêtement est revêtu sur une surface d'étanchéité et un deuxième revêtement est appliqué sur une surface d'étanchéité correspondante, dans lequel ledit deuxième revêtement est choisi dans le groupe constitué de WC-CoCr, WC-Co, WC-Ni, carbure de chrome-NiCr et d'alliages métalliques à base de cobalt.

2. Système de revêtement protecteur selon la revendication 1, dans lequel ledit revêtement de pulvérisation thermique à base de carbure est constitué sensiblement d'un mélange de poudres d'un matériau de carbure de tungstène-cobalt chrome et de 5 % en poids à 35 % en poids d'un alliage de cobalt métallique.

3. Système de revêtement protecteur selon la revendication 1, dans lequel lesdites au moins une ou plusieurs surfaces d'étanchéité sont un composant d'obturateur ou un composant de siège.

4. Système de revêtement protecteur selon la revendication 1, dans lequel ladite composition de pulvérisation thermique à base de carbure est choisie dans le groupe constitué de WC-CoCr, WC-Co, WC-Ni, carbure de chrome-NiCr et alliages métalliques à base de cobalt.

5. Système de revêtement protecteur selon la revendication 1, dans lequel ledit DLC a une épaisseur de 1 à 4 µm.

6. Appareil traité en surface comprenant :
une vanne à obturateur incluant une cavité et un passage d'écoulement s'étendant le long d'un intérieur dudit corps et traversant ladite cavité ;
ladite vanne étant définie en outre au moins en partie par un siège et un obturateur, ledit siège étant fixé au corps au niveau d'un emplacement défini par une intersection de ladite cavité et dudit passage d'écoulement ;
ledit obturateur ayant une face de mise en prise qui vient en prise d'une manière coulissante avec une face correspondante dudit siège ;
dans lequel ladite face de mise en prise de l'obturateur et le siège sont revêtus avec le système de revêtement protecteur selon l'une quelconque des revendications précédentes.
